(19) Europäisches Patentamt
European Patent Office
Office européen des brevets

(11) EP 2 073 238 B1

(12) EUROPEAN PATENT SPECIFICATION

(45) Date of publication and mention of the grant of the patent:
**01.11.2017 Bulletin 2017/44**

(51) Int Cl.:
***H01H 59/00*** *(2006.01)*     *H01H 1/00* *(2006.01)*

(21) Application number: **08171425.5**

(22) Date of filing: **12.12.2008**

(54) **Mems switch with improved standoff voltage control**

MEMS-Schalter mit verbesserter Spannungsfestigkeitregelung

Interrupteur MEMS avec contrôle de tension de tenue amélioré

(84) Designated Contracting States:
**DE FR GB IT**

(30) Priority: **21.12.2007 US 962178**

(43) Date of publication of application:
**24.06.2009 Bulletin 2009/26**

(73) Proprietor: **General Electric Company**
**Schenectady, NY 12345 (US)**

(72) Inventors:
 • **Premerlani, William James**
 **Scotia, NY 12302 (US)**
 • **Keimel, Christopher Fred**
 **Schenectady, NY 12309 (US)**
 • **Subramanian, Kanakasabapathi**
 **Clifton Park, NY 12065 (US)**
 • **Wang, Xuefeng**
 **Schenectady, NY 12309 (US)**
 • **Aimi, Marco Francesco**
 **Niskayuna, NY 12309 (US)**

(74) Representative: **Illingworth-Law, William**
**Illingworth**
**GPO Europe**
**GE International Inc.**
**The Ark**
**201 Talgarth Road**
**Hammersmith**
**London W6 8BJ (GB)**

(56) References cited:
WO-A1-00/52722     WO-A1-02/073673
WO-A1-02/073691     WO-A1-03/032349
US-A- 5 619 061      US-A1- 2005 052 821
US-A1- 2006 144 681   US-A1- 2007 229 204
US-A1- 2007 236 307

## Description

BACKGROUND

Embodiments of the invention relate generally to a micro-electromechanical system (MEMS) switch.

Microelectromechanical systems (MEMS) generally refer to micron-scale structures that can integrate a multiplicity of functionally distinct elements such as mechanical elements, electromechanical elements, sensors, actuators, and electronics, on a common substrate through micro-fabrication technology. MEMS generally range in size from a micrometer to a millimeter in a miniature sealed package. A MEMS switch has a movable actuator that is moved toward a stationary electrical contact by the influence of a gate or electrode positioned on a substrate.

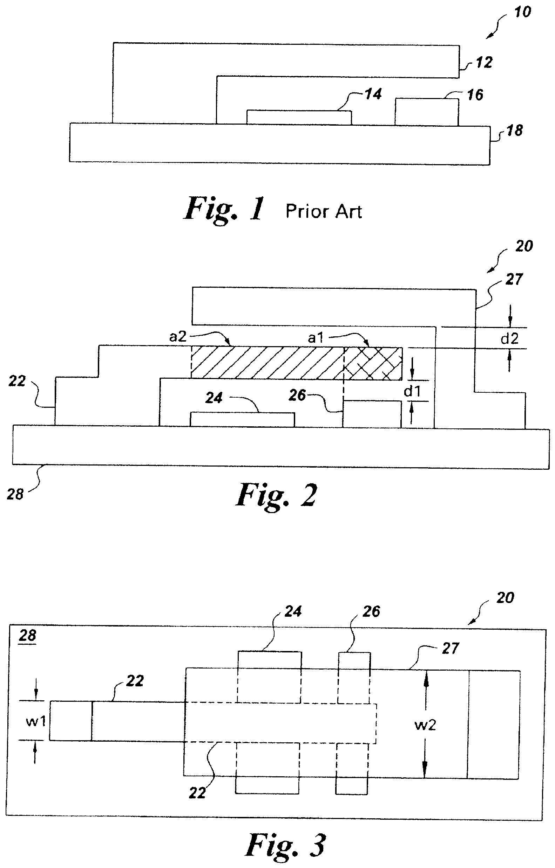

FIG. 1 illustrates a conventional MEMS switch in an open or non-conducting state according to the prior art. The MEMS switch 10 includes a substrate 18, a movable actuator 12, a contact 16 and control electrode 14 mechanically coupled to the substrate 18. In operation, the movable actuator 12 is moved toward the contact 16 by the influence of a control electrode 14 (also referred to as a gate or gate driver) positioned on the substrate 18 below the movable actuator 12. The movable actuator 12 may be a flexible beam that bends under applied forces such as electrostatic attraction, magnetic attraction and repulsion, or thermally induced differential expansion, that closes a gap between a free end of the beam and the stationary contact 16. The movable actuator 12 is normally held apart from the stationary contact 16 in the de-energized state through the spring stiffness of the movable electrode. However, if a large enough voltage is provided across the stationary contact 16 and the movable electrode 12, a resulting electrostatic force can cause the movable electrode 12 to self-actuate without any gating signal being provided by control electrode 14.

Power system applications of MEMS switches are beginning to emerge, such as replacements for fuses, contactors, and breakers. One of the important design considerations in constructing a power switching device with a given overall voltage and current rating is the underlying voltage and current rating of the individual switches used in the array of switches that comprise the device. In particular, the voltage that the individual switches can withstand across their power contacts is an important parameter. There are several factors and effects that determine the voltage rating of an individual MEMS switch. One such factor is the self-actuation voltage.

In a MEMS switch, the self-actuation voltage is an effect that places an upper bound on the voltage capability of the switch. Electrostatic forces between the line and load contacts (e.g. between the movable actuator and stationary contact) will cause the movable actuator to self-actuate or make contact with the stationary contact when the voltage between across the actuator and contact exceeds a certain threshold. In certain current switching applications, this self-actuation can result in catastrophic failure of the switch or downstream systems Document WO 00/52722 discloses a MEMS switch according to the preamble of claim 1. WO-A-2002/073673 concerns a micro-electro-mechanical switch including at least one portion of a conductive line in a chamber, a beam with an imbedded charge, and a pair of control electrodes on opposing sides of the beam. A conductive section of the beam has an open position spaced away from the conductive line, and each of the control electrodes is spaced away from the beam to control movement of the beam. US-A-2007/229204 concerns a micro-electromechanical modulating element including a movable portion that is rotationally displaced and comprises a micro-mirror portion. The reflecting direction of light radiated to the micro-mirror portion is thereby switched.

US-A-2005/052821 concerns a variable capacitance element comprising a movable electrode provided between a first, fixed side driving electrode and second and third side driving electrodes which are movable electrodes.

BRIEF DESCRIPTION

The present invention provides a MEMS switch as defined in appended claim 1. The MEMS switch includes a substrate, a movable actuator coupled to the substrate and having a first side and a second side, a first fixed electrode coupled to the substrate and positioned on the first side of the movable actuator to generate a first actuation force to pull the movable actuator toward a conduction state, and a second fixed electrode coupled to the substrate and positioned on the second side of the movable actuator to generate a second actuation force to pull the movable actuator toward a non-conducting state, and a fixed contact mechanically coupled to the substrate, wherein in the conduction state the movable actuator makes electrical contact with the fixed contact. According to the invention, the fixed contact is electrically coupled to the second fixed control electrode such that whatever voltage happens to exist between the fixed contact and the movable actuator will also appear between the movable actuator and the second fixed control electrode. A method of fabricating a MEMS switch is also described. The method includes forming a first fixed control electrode and a fixed contact on an insulating layer on a substrate, forming a movable actuator on the insulating layer such that the movable actuator overhangs the first fixed control electrode and the contact and forming a second fixed control electrode on the insulating layer and overhanging the movable actuator. The method further includes releasing the movable actuator to allow the actuator to be pulled toward a first conduction state with the contact in response to a first actuation force generated between the first fixed control electrode and the movable actuator, and a second non-conducting state in response to a second actuation force generated between the second fixed control electrode and the movable actuator.

In a further example, not belonging to the invention a MEMS switch array is provided. The MEMS switch array includes a substrate, a first movable actuator coupled to the substrate and having a top side and a bottom side, and a second movable actuator coupled to the substrate and having a top side and a bottom side. The MEMS array further includes a first fixed control electrode coupled to the substrate and positioned on the bottom side of the first and second movable actuators to generate a first actuation force to pull the movable actuators toward a conduction state, and a second fixed control electrode coupled to the substrate and positioned on the top side of the first and second movable actuators to generate a second actuation force to pull the movable actuators toward a non-conducting state.

DRAWINGS

These and other features, aspects, and advantages of the present invention will become better understood when the following detailed description is read with reference to the accompanying drawings in which like characters represent like parts throughout the drawings, wherein:

FIG. 1 illustrates a conventional MEMS switch in an open or non-conducting state according to the prior art;
FIG. 2 is a schematic diagram illustrating one example of a MEMS switch having improved standoff voltage control;
FIG. 3 is a schematic diagram illustrating a top view of MEMS switch 20 of FIG. 2;
FIG. 4 and FIG. 5 are schematic diagrams respectively illustrating side and top views of a MEMS switch 30 according to an alternative example;
FIG. 6 is a schematic diagram illustrating a MEMS switch 40 in accordance with a further example;
FIG. 7 is a schematic diagram illustrating a MEMS switch 50 in accordance with an embodiment of the invention;
FIG. 8 is a schematic diagram illustrating a MEMS switch 60 in accordance with another embodiment of the invention; and
Figures 9-30 illustrate an example fabrication process for fabricating a MEMS switch 70 having improved standoff voltage control.

DETAILED DESCRIPTION

In the following detailed description, numerous specific details are set forth in order to provide a thorough understanding of various embodiments of the present invention. However, those skilled in the art will understand that embodiments of the present invention may be practiced without these specific details, that the present invention is not limited to the depicted embodiments, and that the present invention may be practiced in a variety of alternative embodiments. In other instances, well known methods, procedures, and components have not been described in detail. Furthermore, various operations may be described as multiple discrete steps performed in a manner that is helpful for understanding embodiments of the present invention. However, the order of description should not be construed as to imply that these operations need be performed in the order they are presented, nor that they are even order dependent. Lastly, the terms "comprising", "including", "having", and the like, as well as their inflected forms as used in the present application, are intended to be synonymous unless otherwise indicated.

FIG. 2 is a schematic diagram illustrating a MEMS switch having improved standoff voltage control.

In the illustrated example, MEMS switch 20 includes a movable actuator 22 mechanically coupled to a substrate 28. In one example, the movable actuator 22 is fully or partially conductive. The substrate 28 may be conductive, semi-conductive or insulating. In an example where the substrate 28 is conductive, the ubstrate may be coated with an insulating or electrical isolation layer (not illustrated) to prevent undesirable shorting between and amongst switch contacts/electrodes and the movable actuator. Non-limiting examples of conducting substrates include those formed from silicon and germanium, whereas non-limiting examples of an electrical isolation layer include silicon nitride, silicon oxide, and aluminum oxide.

MEMS switch 20 further includes a first electrode 24 (also referred to as a gate or control electrode) and a contact 26. An electrostatic force may be generated between the first electrode 24 and the movable actuator 22 upon application of a voltage differential between the two components. Thus, upon actuation, the movable actuator 22 is attracted towards the first electrode 24 and eventually makes electrical contact with contact 26. However, as was previously described, in high voltage applications, conventional MEMS switches are prone to self-actuating even when there is no signal applied to the first electrode 24. In accordance with one aspect of the present invention, a second electrode (also referred to as a counter electrode) 27 is provided to generate a second actuation force opposing the self-actuation force such that the movable actuator is pulled toward a non-conducting state away from the contact 26. The second electrode 27 is coupled to the same substrate 28 as the moveable actuator 22 and is positioned over (e.g., on the side parallel to and opposite the substrate 28) the moveable actuator 22 and at least partially over contact 26. By fabricating the counter electrode 27 on the same substrate as the movable actuator 22, variations in electrode spacing between the movable actuator 22 and the counter electrode 27 can be eliminated through tightly controlled photolithographic processes. The electrostatic force present between the substrate contact 26 and the movable actuator 22 can be approximately computed as the force across a capacitor's plates as illustrated by Eqn. (1), where the plate area is the common area of overlap of the two electrodes:

$$F_{electrostatic} = \varepsilon_0 \cdot A \cdot \frac{V^2}{g^2}$$

$F_{electrostatic} = $ electrostatic attraction force, newtons

$\varepsilon_0 = 8.85 \cdot 10^{-12}$ farads/meter **Eqn. (1)**

$A = $ overlap area, meter$^2$

$V = $ voltage across the gap, volts

$g = $ contact gap, meters

Thus, as the voltage differential across the gap between the contact 26 and the movable actuator 22 increases, or as the overlap area (a1) increases, or as the gap (d1) decreases, the larger the resulting electrostatic force will become. Similarly, as the voltage differential across the gap between the electrode 27 and the movable actuator 22 increases, or as the overlap area (a2) increases, or as the gap (d2) decreases, the larger the resulting electrostatic force will become. Accordingly, the counter electrode 27 may be designed based upon the desired standoff voltage. In one embodiment, the distance d2 is greater than d1. In one embodiment, a2 is greater than a1.

In one embodiment, the voltage level between the first electrode 24 and the movable actuator 22 is separately controlled from the voltage level between the movable actuator 22 and the counter electrode 27. In one embodiment, when it is desirable to maintain the switch in a non-conduction (e.g., open) state, the applied voltage between the first electrode 24 and the movable actuator 22 can be set to zero or another relatively low value, while the applied voltage between the counter electrode 27 and the movable actuator 22 can be set to a relatively higher value. When it is desirable to maintain the switch in a conducting (e.g., closed) state, the applied voltage between the first electrode 24 and the movable actuator 22 can be set to a relatively high value, while the applied voltage between the counter electrode 27 and the movable actuator 22 can be set to zero or a relatively lower value. According to the invention, the counter electrode 27 is electrically coupled to the contact 26 such that whatever voltage happens to exist between the contact 26 and the movable actuator 22 will also appear between the movable actuator 22 and the counter electrode 27. By appropriately selecting the size of the counter electrode 27 as well as the spacing between the counter electrode 27 and the movable actuator 22, the self-actuating force generated between the contact 26 and the movable actuator 22 can be balanced with the counter actuation force generated between the movable actuator 22 and the counter electrode 27.

As used herein, the term "above" is intended to refer to a location that is farther away from the substrate 28 than the referenced object, while the term "below" is intended to refer to a location that closer to the substrate 28 than the referenced object. For example, if an item is "above" the movable actuator 22, then the item is farther away from the substrate 28 than the referenced movable actuator 22. In one embodiment, the MEMS switch 20 may include an isolator (not illustrated) positioned above the movable actuator 22 to prevent the movable actuator from making contact with the counter electrode 27. In one embodiment, the isolator may be fabricated as part of counter electrode 27 or as a separate component. The isolator may be formed from a material having insulating, highly resistive or dielectric properties. Further, the isolator may take the form of a rigid or semi-rigid post or pillar, or the isolator may be deposited on the counter electrode as a coating. Moreover, the isolator may be fabricated on either the underside (e.g., on the same side as the substrate 28) of the counter electrode 27 or on the top side (e.g., on the side farther away from the substrate 28) of the movable actuator 22. In one embodiment, while in a non-conducting state, the movable actuator 22 may be positioned in physical contact with the counter electrode 27 while remaining electrically isolated from the counter electrode 27. In another embodiment, while in a non-conducting state the movable actuator 22 may be attracted towards the counter electrode 27 but remain mechanically and electrically isolated from the counter electrode 27. In such a non-conducting state, the movable actuator 22 may remain in a stationary position.

FIG. 3 is a schematic diagram illustrating a top view of MEMS switch 20 of FIG. 2. As can be seen by FIG. 3, the counter electrode 27 is arranged in parallel with the movable actuator 22. As previously mentioned, the area of the overlap between the counter electrode 27 and the movable actuator 22 can be designed based upon the electrostatic force that is desirable between the two components. For example, as illustrated in FIG. 3, the width (w2) of the counter electrode 27 may be designed to be greater or less than the width (w1) of the movable actuator 22.

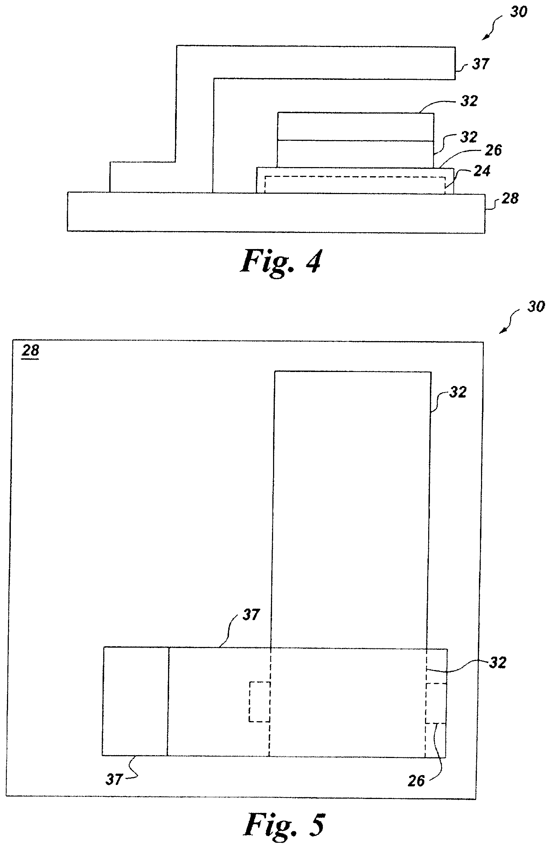

FIG. 4 and FIG. 5 are schematic diagrams respectively illustrating side and top views of a MEMS switch 30 according to an alternative example. The MEMS switch 30 is substantially similar to the MEMS switch 20 of FIG. 2 and FIG. 3. In particular, a counter electrode 37 is provided that is coupled to the same substrate 28 as the movable actuator 22. However, in the illustrated example of FIG. 4 and FIG. 5, the counter electrode 37 is positioned above the movable actuator 22 substantially opposite the contact 26 in an orthogonal relationship to the movable actuator 32.

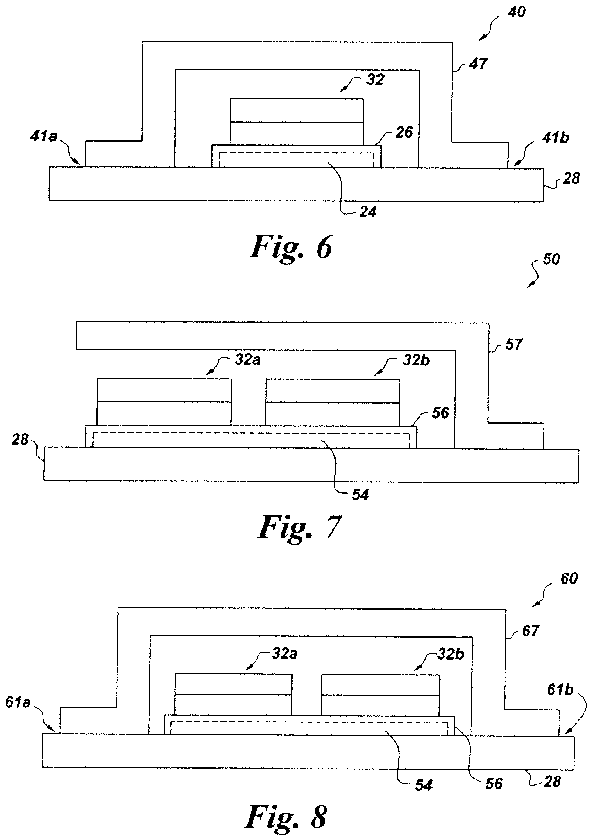

FIG. 6 is a schematic diagram illustrating a MEMS switch 40 in accordance with a further example. As illustrated, MEMS switch 40 is substantially similar to MEMS switch 30 and includes a movable actuator 32, an electrode 24 and a contact 26 all coupled to a substrate 28. However, in FIG. 6, the counter electrode 47 is coupled to the substrate 28 at at least two locations (41a, 41b).

FIG. 7 is a schematic diagram illustrating a MEMS switch 50 in accordance with an embodiment of the present invention. MEMS switch 50 is substantially similar to MEMS switch 30, however MEMS switch 50 includes a counter electrode 57 that overlaps at least two movable actuators 32. The movable actuators 32 may be electrically isolated or coupled in a series, or parallel, or series-parallel arrangement. In the illustrated embodiment, the movable actuators 32 are shown as sharing a common load contact 56 and a common gate driver (e.g., electrode 54). However, the movable actuators 32 may instead be separately actuated and the movable actuators 32 may electrically couple separate load circuits.

FIG. 8 is a schematic diagram illustrating a MEMS switch 60 in accordance with yet another embodiment of the invention. As illustrated, MEMS switch 60 is substantially similar to MEMS switch 40 in that the counter electrode 67 is coupled to the substrate 28 at at least two locations (61a, 61b). However, in addition, the counter electrode 67 of FIG. 8 overlaps at least two movable actuators 32. As with MEMS switch 50 of FIG. 7, the movable actuators 32 may be electrically isolated or coupled in a series, or parallel, or series-parallel arrangement. In the illustrated embodiment, the movable actuators 32 are shown as sharing a common load contact 56 and a common gate driver (e.g., electrode 54). However, the movable actuators 32 may instead be separately actuated and the movable actuators 32 may electrically couple separate load circuits.

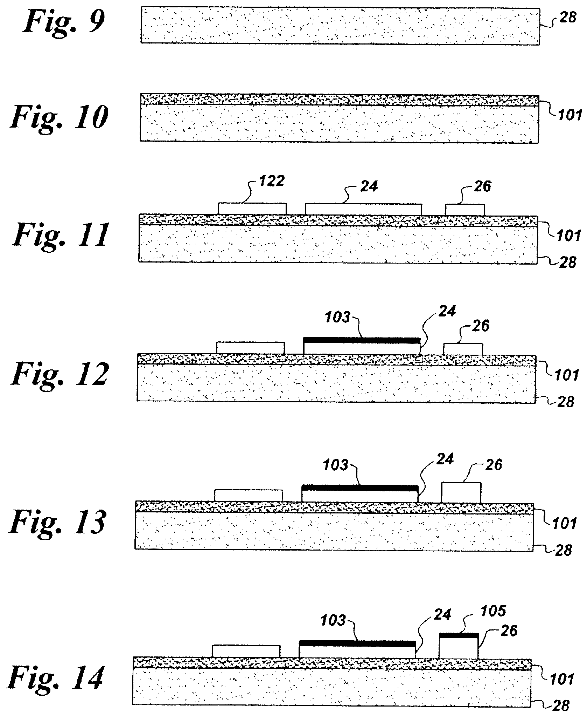

Figures 9-30 illustrate an example fabrication process for fabricating a MEMS switch 70 having improved standoff voltage control in accordance with embodiments of the invention. Although the MEMS switch 70 appears similar in form to MEMS switch 20 of FIG. 2 and FIG. 3, the following fabrication process may be adapted to fabricate any of the previously described MEMS switches having improved standoff voltage control.

In FIG. 9, a substrate 28 is provided. In one embodiment the substrate comprises silicon. In FIG. 10 an electrical isolation layer 101 may be deposited on the substrate 28 using chemical vapor deposition or thermal oxidation methods. In one embodiment, the electrical isolation layer 101 includes Si3N4. In FIG. 11, conductive electrodes are deposited and patterned on to the electrical isolation layer 101. More specifically, a contact 26, a control electrode 24 and an anchor contact 122 are formed. In one embodiment, a contact 26, a control electrode 24 and an anchor contact 122 comprise a conductive material such as gold and may be formed from the same mask. It should be noted that the anchor contact 122 could be formed as part of the movable actuator (to be described), however fabrication can be simplified through the addition of the anchor contact 122. In FIG. 12, an insulation layer 103 is deposited on the control electrode 24 in order to prevent shorting between the movable actuator and the control electrode 24. In one embodiment, the insulation layer 103 may be formed from SiN4, however other insulating, or highly resistive coatings may be used. In another embodiment, the insulation layer can be formed on the underside of the movable electrode. Alternatively, a mechanical post may be fabricated between the control electrode 24 and the contact 26 to prevent the movable actuator from contacting the control electrode 24. In such a case, the insulation layer 103 may not be needed.

FIG. 13 and FIG. 14 illustrate two processing steps that may be omitted completely depending upon which features are desired for the MEMS switch 70. More specifically, FIG. 13 illustrates additional conductive material being deposited on contact 26 to make the contact taller. This may be useful to decrease the distance that the movable actuator needs to travel and to further prevent the movable actuator from contacting the control electrode 24. However, it should be noted that the closer the contact 26 is to the movable electrode, the greater the resulting electrostatic force will be between the two components as shown by Eqn. 1. In FIG 14, an additional contact material 105 is deposited on the contact 26. The contact material may be used to enhance conduction between the contact 26 and the movable actuator while prolonging life of the switch.

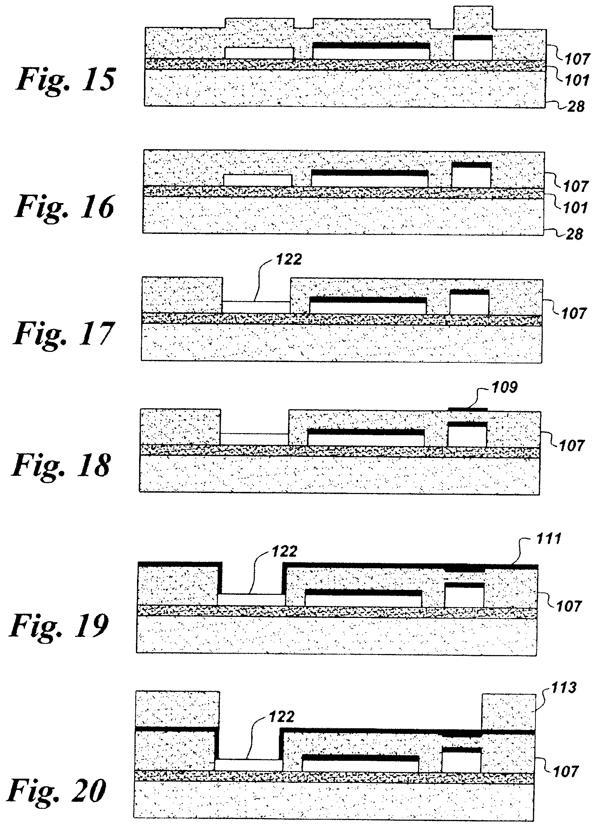

In FIG. 15, a sacrificial layer 107 is deposited on top of the contact 26, the control electrode 24 and the anchor contact 122. In one embodiment, the sacrificial layer 107 may be SiO2. FIG. 16 illustrates an optional polishing step where the sacrificial layer is polished by, for example, chemical-mechanical polishing. In FIG. 17 the sacrificial layer 107 is etched to expose the anchor contact 122. In the event it is desirable to add a contact material layer on movable actuator, an additional contact 109 may be patterned as illustrated in FIG. 18.

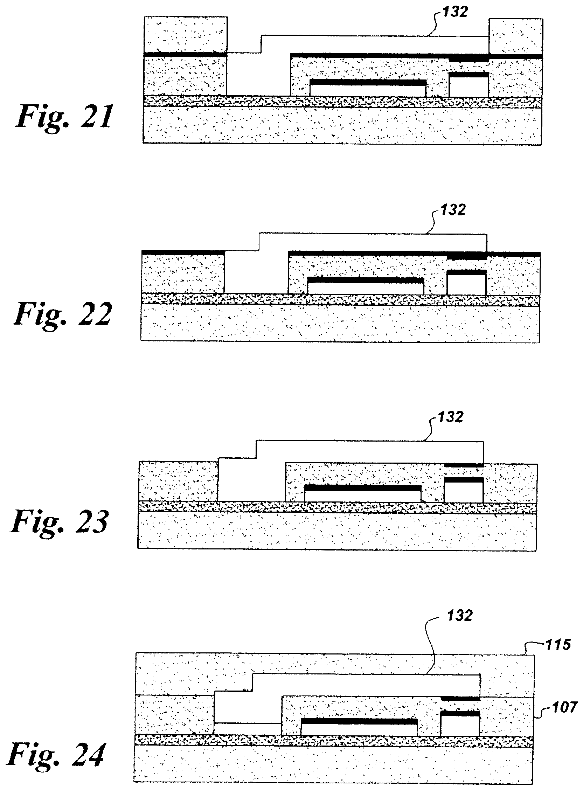

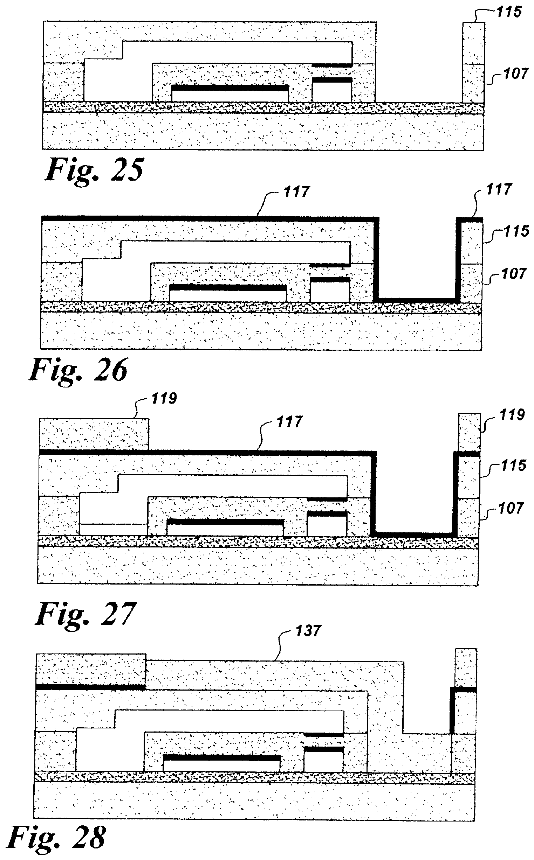

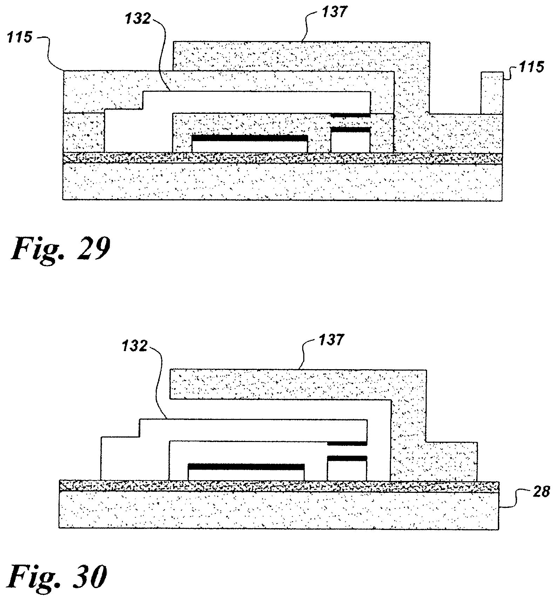

Figures 19-23 illustrate the formation of a movable actuator 132. In one embodiment, the movable actuator 132 is formed through an electroplating process. In FIG. 19, a seed layer 111 is provided for the electroplating process. In FIG. 20 a mold 113 is patterned for electroplating the movable actuator 132, which is shown in FIG. 21. In FIG. 22 and FIG. 23, the electroplating mold 113 and the seed layer 111 are removed. Once the movable actuator 132 has been formed, a counter electrode 137 as described herein may be formed. As part of the counter electrode process, a second sacrificial layer 115 may be deposited and optionally polished as illustrated in FIG. 24. In one embodiment, the second sacrificial layer may comprise SiO2. In FIG. 25, both sacrificial layer 115 and sacrificial layer 107 are etched in the location where the counter electrode 137 will be formed as shown. An electroplating seed layer 117 and an electroplating mold 119 are then formed as illustrated in FIG. 26 and FIG. 27, respectively. In FIG. 28 the counter electrode 137 is electroplated. In one embodiment, the counter electrode 137 is formed from a conductive material such as gold. In FIG. 29 and FIG. 30, the electroplating mold 119 and seed layer 117 are removed, and in FIG 30 the sacrificial layer 115 is removed to free the counter electrode.

## Claims

1. A MEMS switch (20, 30, 40) comprising:

   a substrate (28);
   a movable actuator (22) coupled to the substrate (28) and having a first side and a second side;
   a first fixed control electrode (24) coupled to the substrate (28) and positioned on the first side of the movable actuator (22) to generate a first actuation force to pull the movable actuator (22) toward a conduction state;
   a second fixed control electrode (27) coupled to the substrate (28) and positioned on the second side of the movable actuator (22) to generate a second actuation force to pull the movable actuator (22) toward a non-conducting state; and
   a fixed contact (26) mechanically coupled to the substrate (28), wherein in the conduction state the movable actuator (22) makes electrical contact with the fixed contact (26), **characterised in that** the fixed contact (26) is electrically coupled to the second fixed control electrode (27) such that whatever voltage happens to exist between the fixed contact (26) and the movable actuator (22) will also appear between the movable actuator (22) and the second fixed control electrode (27).

2. The MEMS switch of claim 1, whererin the fixed contact (26) is electrically coupled to a load circuit.

3. The MEMS switch of claim 1, wherein the second fixed control electrode (27) is coupled to the substrate at at least two locations.

4. The MEMS switch of claim 1 or claim 3, wherein the movable actuator (22) is stationary in the non-conducting state.

5. The MEMS switch of any one of the preceding claims, further comprising an isolator positioned above the movable actuator (22) to prevent the movable actuator from making contact with the second fixed control electrode (27).

6. The MEMS switch of claim 5, wherein the movable actuator (22) is conductive.

## Patentansprüche

1. MEMS-Schalter (20, 30, 40), umfassend:

   ein Substrat (28);
   ein bewegliches Betätigungsglied (22), das an das Substrat (28) gekoppelt ist und eine erste Seite und eine zweite Seite aufweist;
   eine erste starre Steuerelektrode (24), die an das Substrat (28) gekoppelt ist und auf der ersten Seite des beweglichen Betätigungsglieds (22) angeordnet ist, um eine erste Betätigungskraft zum Ziehen des beweglichen Betätigungsglieds (22) zu einem Leitungszustand hin zu erzeugen;
   eine zweite starre Steuerelektrode (27), die an das Substrat (28) gekoppelt ist und auf der zweiten Seite des beweglichen Betätigungsglieds (22) angeordnet ist, um eine zweite Betätigungskraft zum Ziehen des beweglichen Betätigungsglieds (22) zu einem nichtleitenden Zustand hin zu erzeugen; und
   einen ersten Kontakt (26), der mechanisch an das Substrat (28) gekoppelt ist, wobei das bewegliche Betätigungsglied (22) im Leitungszustand elektrischen Kontakt mit dem starren Kontakt (26) herstellt, **dadurch gekennzeichnet, dass** der starre Kontakt (26) elektrisch an die zweite starre Steuerelektrode (27) gekoppelt ist, sodass jegliche Spannung, die zwischen dem starren Kontakt (26) und dem beweglichen Betätigungsglied (22) vorliegen mag, ebenfalls zwischen dem beweglichen Betätigungsglied (22) und der zweiten starren Steuerelektrode (27) auftritt.

**2.** MEMS-Schalter nach Anspruch 1, wobei der starre Kontakt (26) elektrisch an einen Lastkreis gekoppelt ist.

**3.** MEMS-Schalter nach Anspruch 1, wobei die zweite starre Steuerelektrode (27) an zumindest zwei Stellen an das Substrat gekoppelt ist.

**4.** MEMS-Schalter nach einem der Ansprüche 1 oder 3, wobei das bewegliche Betätigungsglied (22) im nichtleitenden Zustand unbeweglich ist.

**5.** MEMS-Schalter nach einem der vorhergehenden Ansprüche, ferner umfassend einen Isolator, der über dem beweglichen Betätigungsglied (22) angeordnet ist, zum Verhindern, dass das bewegliche Betätigungsglied Kontakt mit der zweiten starren Steuerelektrode (27) herstellt.

**6.** MEMS-Schalter nach Anspruch 5, wobei das bewegliche Betätigungsglied (22) leitend ist.

**Revendications**

**1.** Commutateur MEMS (20, 30, 40) comprenant :

un substrat (28) ;
un actionneur mobile (22) couplé au substrat (28) et ayant une premier côté et un second côté ;
une première électrode de commande fixe (24) couplée au substrat (28) et positionnée sur le premier côté de l'actionneur mobile (22) pour générer une première force d'actionnement afin d'amener l'actionneur mobile (22) vers un état de conduction ;
une seconde électrode de commande fixe (27) couplée au substrat (28) et positionnée sur le second côté de l'actionneur mobile (22) pour générer une seconde force d'actionnement afin d'amener l'actionneur mobile (22) vers un état non conducteur ; et
un contact fixe (26) couplé mécaniquement au substrat (28), dans lequel, à l'état de conduction, l'actionneur mobile (22) établit un contact électrique avec le contact fixe (26), **caractérisé en ce que** le contact fixe (26) est couplé électriquement à la seconde électrode de commande fixe (27) de sorte que, quelle que soit la tension qui pourrait exister entre le contact fixe (26) et l'actionneur mobile (22), elle apparaîtra également entre l'actionneur mobile (22) et la seconde électrode de commande fixe (27).

**2.** Commutateur MEMS selon la revendication 1, dans lequel le contact fixe (26) est couplé électriquement à un circuit de charge.

**3.** Commutateur MEMS selon la revendication 1, dans lequel la seconde électrode de commande fixe (27) est couplée au substrat en au moins deux emplacements.

**4.** Commutateur MEMS selon la revendication 1 ou la revendication 3, dans lequel l'actionneur mobile (22) est stationnaire à l'état non conducteur.

**5.** Commutateur MEMS selon l'une quelconque des revendications précédentes, comprenant en outre un isolant positionné au-dessus de l'actionneur mobile (22) pour empêcher l'actionneur mobile d'établir un contact avec la seconde électrode de commande fixe (27).

**6.** Commutateur MEMS selon la revendication 5, dans lequel l'actionneur mobile (22) est conducteur.

**Fig. 1** Prior Art

**Fig. 2**

**Fig. 3**

**Fig. 4**

**Fig. 5**

**Fig. 6**

**Fig. 7**

**Fig. 8**

10

*Fig. 9* 28

*Fig. 10* 101

*Fig. 11* 122 24 26
101
28

*Fig. 12* 103 24 26
101
28

*Fig. 13* 103 24 26
101
28

*Fig. 14* 103 24 105 26
101
28

**Fig. 15**

107
101
28

**Fig. 16**

107
101
28

**Fig. 17**

122

107

**Fig. 18**

109

107

**Fig. 19**

122
111

107

**Fig. 20**

122
113

107

*Fig. 21*

132

*Fig. 22*

132

*Fig. 23*

132

*Fig. 24*

132

115

107

**Fig. 25**

**Fig. 26**

**Fig. 27**

**Fig. 28**

**Fig. 29**

**Fig. 30**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 0052722 A
- WO 2002073673 A
- US 2007229204 A
- US 2005052821 A